(19) Europäisches Patentamt / European Patent Office / Office européen des brevets

(11) **EP 2 801 833 A1**

(12) **EUROPEAN PATENT APPLICATION**

(43) Date of publication:
**12.11.2014 Bulletin 2014/46**

(51) Int Cl.:
*G01R 15/20* (2006.01)      *G01R 15/09* (2006.01)

(21) Application number: **14158606.5**

(22) Date of filing: **10.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.05.2013   US 201313890388**

(71) Applicant: **Hamilton Sundstrand Corporation Windsor Locks, CT 06096-1010 (US)**

(72) Inventors:
• **Rozman, Gregory I.**
  **Rockford, IL 61114 (US)**
• **Gieras, Jacek F.**
  **Glastonbury, CT 06033 (US)**
• **Moss, Steven J.**
  **Rockford, IL 61114 (US)**

(74) Representative: **Hughes, Andrea Michelle Dehns**
  **St Bride's House**
  **10 Salisbury Square**
  **London EC4Y 8JD (GB)**

(54) **Regulated magnetic flux density for extended current measurement**

(57)      A current sensor senses a primary current in a conductor. The current sensor 12 includes a core 40, a sensing device 24, and a magnetizing coil 22. The core is configured so that the primary current generates a first magnetic field concentrated in the core. A magnetic flux density of the core is established based upon the first magnetic field and a magnetic permeability of the core.

The sensing device senses the magnetic flux density of the core and provides a voltage representative of the primary current. The magnetizing coil receives a magnetizing current when the primary current is greater than a threshold value. The magnetizing coil generates a coil magnetic field in response to the magnetizing current to decrease the magnetic permeability of the core.

FIG. 1

# EP 2 801 833 A1

## Description

### BACKGROUND

Solid state power controllers (SSPCs) are often used in power distribution systems to protect electrical systems from overload conditions. SSPCs often employ $I^2t$ over-current protection. $I^2t$ protection allows over-currents for a short amount of time based upon a threshold power flow. These over-currents may be, for example, 800% to 1000% of the steady-state current. Because of this, the SSPCs are required to have a high accuracy current sensor with a wide measuring range. For example, if a steady-state current is 200 amps, the current sensor must be able to accurately sense up to 2000 amps.

In the past, resistive shunts and Hall effect sensors have been used for current sensing in SSPCs. Resistive shunts, however, have power losses that can be quite high when required to support large over-currents. Hall effect sensors are non-contact sensors that sense current based upon a magnetic field created by current flowing in a conductor. These sensors include a core that is implemented around the conductor in which most of the magnetic field generated by the current is concentrated. The core includes an air gap that includes a Hall effect device. The Hall effect device is mounted in the air gap of the core at a right angle to the concentrated magnetic field. The Hall effect device produces a voltage that is proportional to the current in the conductor. The larger the current in the conductor, the larger the size of the Hall effect sensor that is required in order to provide accurate measurements. It is desirable to limit the size of these current sensors in order to reduce the size and weight of the SSPC.

### SUMMARY

A current sensor senses a primary current in a conductor. The current sensor includes a core, a sensing device, and a magnetizing coil. The core is configured so that the primary current generates a first magnetic field concentrated in the core. A magnetic flux density of the core is established based upon the first magnetic field and a magnetic permeability of the core. The sensing device senses the magnetic flux density of the core and provides a voltage representative of the primary current. The magnetizing coil receives a magnetizing current when the primary current is greater than a threshold value. The magnetizing coil generates a coil magnetic field in response to the magnetizing current to decrease the magnetic permeability of the core.

### BRIEF DESCRIPTION OF THE DRAWINGS

FIG. 1 is a circuit diagram illustrating a system for sensing current utilizing regulated magnetic flux density.
FIG. 2 is a cross-sectional view illustrating a current sensor that utilizes regulated magnetic flux density.

### DETAILED DESCRIPTION

A current sensor is disclosed herein utilizing regulated magnetic flux density for extended measuring range. The current sensor is implemented to sense a primary current in a conductor. The current in the conductor produces a magnetic field that is concentrated in a core of the current sensor. A Hall effect device is mounted within an air gap of the core. The Hall effect device produces an output voltage based upon a magnetic flux density of the core. This output voltage is directly proportional to the current in the conductor.

During overload conditions, the magnetic flux density in the core can become too great for the Hall effect device to function properly. During these overload conditions, a magnetizing current is provided to a magnetizing coil to generate a magnetic field. This field is provided to the core of the current sensor to decrease the permeability of the core. By decreasing the permeability, the flux density in the core for a given magnetic field generated by the primary current is decreased. Because the fields generated by over-currents do not produce as great of a flux density in the core, the Hall effect device can function properly without saturation during overload conditions. By decreasing the permeability of the core, the coefficient of proportionality between the output of the Hall effect device and the primary current is changed. Knowing the change in the coefficient of proportionality between the output of the Hall effect device and the primary current, the primary current can be sensed during both steady-state conditions and overload conditions.

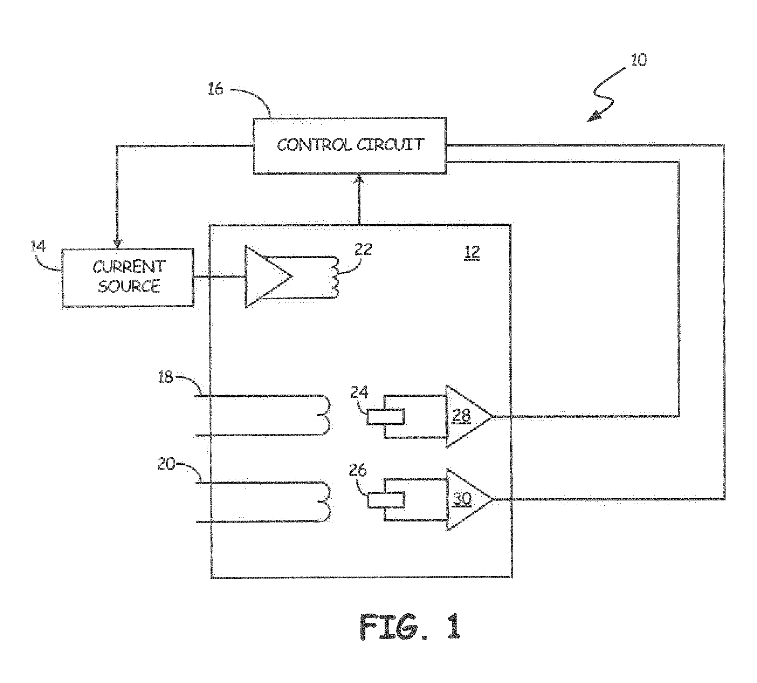

FIG. 1 is a circuit diagram illustrating system 10 for sensing current utilizing regulated magnetic flux density. System 10 may be any system that senses current such as, for example, a solid state power controller (SSPC). System 10 includes current sensor 12, current source 14, control circuit 16, and conductors 18 and 20. Current sensor 12 includes magnetizing coil 22, Hall effect devices 24 and 26, and differential amplifiers 28 and 30. Although illustrated as a dual current sensor monitoring current in two conductors 18 and 20, current sensor 12 may be implemented to monitor current

2

in a single conductor. The two conductors 18 and 20 may be, for example, positive and negative power rails monitored by an SSPC, or may be the same conductor passed through current sensor 12 twice for increased sensitivity.

Control circuit 16 controls current from current source 14 to magnetizing coil 22. When the currents in conductors 18 and 20 are at steady-state conditions such as, for example, two hundred amps, no current is provided to magnetizing coil 22. During overload conditions, when the current in either conductor 18 or 20 is at, for example, 200% to 1000% of the steady-state current, control circuit 16 controls current source 14 to provide a magnetizing current to magnetizing coil 22. Control circuit 16 is any circuit capable of controlling current from current source 14 based upon the outputs of Hall effect devices 24 and 26. Current source 14 is any electric circuit capable of providing at least two values of current. Current source 14 may be controlled using, for example, a switch. When the switch is not conducting, current source 14 provides zero current. When the switch is conducting, current source 14 provides a current such as, for example, one amp.

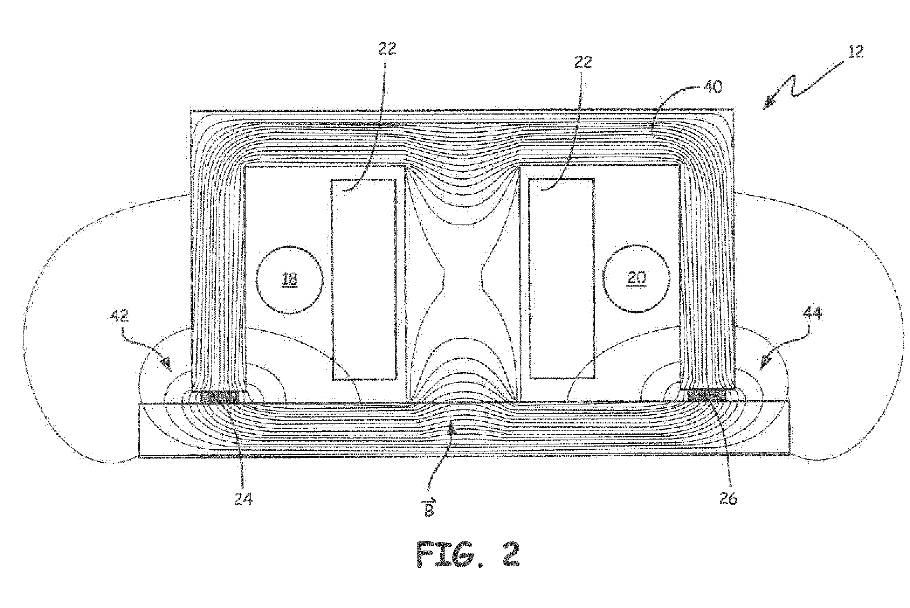

FIG. 2 is a cross-sectional view illustrating current sensor 12 that utilizes regulated magnetic flux density. Current sensor 12 includes magnetizing coil 22, Hall effect devices 24 and 26, core 40, and air gaps 42 and 44. A magnetic field **(H)** is generated by the current in primary conductors 18 and 20. The field **(H)** is concentrated in core 40 and is related to the magnetic flux density (B) of core 40 by the following equation:

$$\mathbf{B} = \mu\,\mu_0\,\mathbf{H} \qquad\qquad (\text{Eq. 1})$$

Where:

$\mathbf{B}$ = magnetic flux density;
$\mathbf{H}$ = magnetic field;
$\mu$ = relative permeability of core 40; and
$\mu_0$ = permeability of free space.

Hall effect devices 24 and 26 are mounted in respective air gaps 42 and 44 perpendicular to the magnetic flux density **(B)** of core 40. Hall effect devices 24 and 26 produce an output voltage proportional to the magnetic flux density **(B).** These output voltages of Hall effect devices 24 and 26 are directly proportional to the currents in respective conductors 18 and 20 with a coefficient of proportionality ($k_H$), which is based upon the following equation:

$$V_H = k_H I_H \qquad\qquad (\text{Eq. 2})$$

Where:

$I_H$ = current in the conductor; and
$V_H$ = output voltage of the respective Hall effect device.

During steady-state operation, the current in magnetizing coil 22 is at a first value, such as zero. When zero current is provided to magnetizing coil 14, the relative permeability ($\mu$) of core 40 is at a first permeability value. This value is any value, and is based upon the material of core 40. Core 40 is made of any suitable material such as, for example, a ferromagnetic material. When no current is provided to magnetizing coil 22, the coefficient of proportionality ($k_H$) between the output of Hall effect devices 24 and 26 and the currents in conductors 18 and 20 is at a first value. This value is based in part upon the relative permeability ($\mu$) of core 40. During steady-state conditions, control circuit 16 of FIG. 1 determines the current in conductors 18 and 20 based upon the output voltages of Hall effect devices 24 and 26 along with the first value of the coefficient of proportionality ($k_H$). The coefficient of proportionality ($k_H$) may be determined by, for example, testing of current sensor 12.

During overload conditions, when the current in either primary conductor 18 or 20 is, for example, 200% to 1000% of the steady-state current, a magnetizing current is provided to magnetizing coil 22. During overload conditions, with no current provided to magnetizing coil 22, the flux density **(B)** in air gaps 42 and 44 may exceed the range of values for which Hall effect devices 24 and 26 function properly. Because of this, current sensor 12 cannot accurately sense these larger currents. When the magnetizing current is provided to magnetizing coil 22, a magnetic field is generated by coil 22 and provided to core 40. Magnetizing coil 22 may be implemented around a portion of core 40 and includes any number of turns. The magnetic field from coil 22 causes the relative permeability ($\mu$) of core 40 to decrease from the first permeability value to a second permeability value. This second value is any value less than the first permeability value and is based upon the current to magnetizing coil 22 and the material of core 40.

By lowering the relative permeability of core 40, the respective flux density **(B)** of core 40 is lowered for a given field **(H)** generated by currents in conductors 18 or 20. By reducing the permeability, and in turn decreasing the flux density **(B)** for a given field **(H),** the flux density **(B)** for over-current conditions is within the range of values for which Hall effect devices 24 and 26 function properly. This way, currents can be accurately sensed by current sensor 12 without using magnetic shunts, creating variable air gaps, or using other methods of reducing the magnetic flux density **(B).** This change in permeability causes a change in the coefficient of proportionality ($k_H$) between Hall effect sensors 24 and 26 and the currents in conductors 18 and 20 from the first value to a second value. Therefore, during overload conditions, when a magnetizing current is provided to magnetizing coil 22, control circuit 16 can determine the current in conductors 18 and 20 based upon the second value for the coefficient of proportionality ($k_H$). The second value of the coefficient of proportionality ($k_H$) may be determined based upon, for example, testing of current sensor 12.

By decreasing the permeability of core 40 based upon the current in conductors 18 and 20, the size, weight and cost of current sensor 12 can be reduced for applications that require accurate sensing of both steady-state currents and over-currents up to, for example, 1000% of the steady-state current. While illustrated as a dual current sensor, current sensor 12 may also be implemented to sense a current in a single conductor.

The following are non-exclusive descriptions of possible embodiments of the present invention.

A current sensor that senses a first current in a first conductor includes, among other things: a core, a first sensing device, and a magnetizing coil. The core is configured so that the first current generates a first magnetic field concentrated in the core. A magnetic flux density of the core is established based upon the first magnetic field and a magnetic permeability of the core. The first sensing device senses the magnetic flux density of the core and provides a first voltage representative of the first current. The magnetizing coil receives a magnetizing current when the first current is greater than a threshold value. The magnetizing coil generates a coil magnetic field in response to the magnetizing current to decrease the magnetic permeability of the core.

The current sensor of the preceding paragraph can optionally include, additionally and/or alternatively, any one or more of the following features, configurations and/or additional components:

The current sensor senses a second current in a second conductor. The second current generates a second magnetic field concentrated in the core. The magnetic flux density of the core is further established based upon the second magnetic field.

A second sensing device senses the magnetic flux density of the core and provides a second voltage representative of the second current. The magnetizing coil receives the magnetizing current when either the first current or the second current is greater than the threshold value.

The first and second sensing devices are Hall effect devices.

The magnetizing current is received from a current source. The current source is controlled by a control circuit based upon the voltage representative of the first current.

A method includes, among other things: concentrating in a core of a current sensor a first magnetic field generated by a first primary current. A magnetic flux density of the core is established based upon the first magnetic field and a permeability of the core. The method further includes sensing the first primary current using a first sensing device of the current sensor based upon a first coefficient of proportionality between an output voltage of the first sensing device and the first primary current, providing a magnetizing current to a magnetizing coil if the first primary current is greater than a threshold value, wherein the magnetizing coil produces a coil magnetic field in response to the magnetizing current that lowers the permeability of the core, and sensing the first primary current using the first sensing device of the current sensor based upon a second coefficient of proportionality between the output voltage of the first sensing device and the first primary current when the first primary current is greater than the threshold value.

The method of the preceding paragraph can optionally include, additionally and/or alternatively, any one or more of the following features, configurations and/or additional components:

Concentrating in the core of the current sensor a second magnetic field generated by a second primary current. The magnetic flux density of the core is further established based upon the second magnetic field.

Sensing the second primary current using a second sensing device of the current sensor based upon the first coefficient of proportionality.

Providing the magnetizing current further includes providing the magnetizing current to the magnetizing coil if the second primary current is greater than the threshold value.

Sensing the second primary current using the second sensing device of the current sensor based upon the second coefficient of proportionality when either the first primary current or the second primary current is greater than the threshold value.

The first and second sensing devices are Hall effect devices.

A system includes, among other things: a current sensor, and a control circuit. The current sensor senses a first current and includes a core, a first sensing device, and a magnetizing coil. The core is configured so that the first current generates a first magnetic field concentrated in the core. A magnetic flux density of the core is established based upon the first magnetic field and a magnetic permeability of the core. The first sensing device senses the magnetic flux density of the core and provides a first voltage representative of the first current. The magnetizing coil receives a magnetizing current when the first current is greater than a threshold value. The magnetizing coil generates a coil magnetic field in response to the magnetizing current to decrease the magnetic permeability of the core. The control circuit determines the first current based upon the output voltage of the first current sensor and provides the magnetizing current to the magnetizing coil when the primary current is greater than a threshold value.

The system of the preceding paragraph can optionally include, additionally and/or alternatively, any one or more of the following features, configurations and/or additional components:

The current sensor senses a second current in a second conductor. The second current generates a second magnetic field concentrated in the core. The magnetic flux density of the core is further established based upon the second magnetic field.

The current sensor further includes a second sensing device that senses the magnetic flux density of the core and provides a second voltage representative of the second current. The magnetizing coil receives the magnetizing current when either the first current or the second current is greater than the threshold value.

The first and second sensing devices are Hall effect devices.

The control circuit provides the magnetizing current to the magnetizing coil from a current source.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the scope of the invention is defined by the appended claims.

**Claims**

1. A current sensor (12) for sensing a first current in a first conductor, the current sensor comprising:

    a core (40) configured so that the first current generates a first magnetic field concentrated in the core, wherein a magnetic flux density of the core is established based upon the first magnetic field and a magnetic permeability of the core;
    a first sensing device (24) that senses the magnetic flux density of the core and provides a first voltage representative of the first current; and
    a magnetizing coil (22) that receives a magnetizing current when the first current is greater than a threshold value, wherein the magnetizing coil generates a coil magnetic field in response to the magnetizing current to decrease the magnetic permeability of the core.

2. The current sensor of claim 1, wherein the current sensor senses a second current in a second conductor, and wherein the second current generates a second magnetic field concentrated in the core, and wherein the magnetic flux density of the core is further established based upon the second magnetic field.

3. The current sensor of claim 2, further comprising:

    a second sensing device (26) that senses the magnetic flux density of the core and provides a second voltage representative of the second current; and
    wherein the magnetizing coil receives the magnetizing current when either the first current or the second current is greater than the threshold value.

4. The current sensor of claim 3, wherein the first and second sensing devices are Hall effect devices.

5. The current sensor of claim 1, wherein the magnetizing current is received from a current source (14), and wherein the current source is controlled by a control circuit (16) based upon the voltage representative of the first current.

6. A method comprising:

    concentrating in a core of a current sensor a first magnetic field generated by a first primary current, wherein a magnetic flux density of the core is established based upon the first magnetic field and a permeability of the core;
    sensing the first primary current using a first sensing device of the current sensor based upon a first coefficient of proportionality between an output voltage of the first sensing device and the first primary current;
providing a magnetizing current to a magnetizing coil if the first primary current is greater than a threshold value, wherein the magnetizing coil produces a coil magnetic field in response to the magnetizing current that lowers the permeability of the core; and
sensing the first primary current using the first sensing device of the current sensor based upon a second coefficient of proportionality between the output voltage of the first sensing device and the first primary current when the first primary current is greater than the threshold value.

7. The method of claim 6, further comprising concentrating in the core of the current sensor a second magnetic field generated by a second primary current, wherein the magnetic flux density of the core is further established based upon the second magnetic field.

8. The method of claim 7, further comprising sensing the second primary current using a second sensing device of the current sensor based upon the first coefficient of proportionality.

9. The method of claim 8, wherein providing the magnetizing current further comprises providing the magnetizing current to the magnetizing coil if the second primary current is greater than the threshold value.

10. The method of claim 9, further comprising sensing the second primary current using the second sensing device of the current sensor based upon the second coefficient of proportionality when either the first primary current or the second primary current is greater than the threshold value.

11. The method of claim 10, wherein the first and second sensing devices are Hall effect devices.

12. A system comprising:

a current sensor (12) as claimed in any of claims 1 to 5; and a control circuit (16) that determines the first current based upon the output voltage of the
first current sensor and provides the magnetizing current to the magnetizing coil when the primary current is greater than a threshold value.

13. The system of claim 12, wherein the control circuit provides the magnetizing current to the magnetizing coil from a current source.

FIG. 1

EP 2 801 833 A1

FIG. 2

Europäisches
Patentamt

European
Patent Office

Office européen
des brevets

## EUROPEAN SEARCH REPORT

Application Number

EP 14 15 8606

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 129 988 B2 (FERMON CLAUDE [FR] ET AL) 6 March 2012 (2012-03-06) | 1-3, 5-10,12, 13 | INV. G01R15/20 G01R15/09 |
| Y | * the whole document * | 4,11 | |
| | ----- | | |
| Y | EP 1 039 307 A1 (TDK CORP [JP]) 27 September 2000 (2000-09-27) | 4,11 | |
| A | * the whole document * | 1-3, 5-10,12, 13 | |
| | ----- | | |
| A | US 2011/204889 A1 (NOMURA MASATOSHI [JP]) 25 August 2011 (2011-08-25) * the whole document * | 1-13 | |
| | ----- | | |

TECHNICAL FIELDS
SEARCHED        (IPC)

G01R

The present search report has been drawn up for all claims

| Place of search | Date of completion of the search | Examiner |
|---|---|---|
| Munich | 8 August 2014 | Kleiber, Michael |

EPO FORM 1503 03.82 (P04C01)

**ANNEX TO THE EUROPEAN SEARCH REPORT
ON EUROPEAN PATENT APPLICATION NO.** EP 14 15 8606

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2014

| Patent document cited in search report | | Publication date | Patent family member(s) | | Publication date |
|---|---|---|---|---|---|
| US 8129988 | B2 | 06-03-2012 | EP | 2038671 A2 | 25-03-2009 |
| | | | FR | 2902890 A1 | 28-12-2007 |
| | | | US | 2009309581 A1 | 17-12-2009 |
| | | | WO | 2007148028 A2 | 27-12-2007 |
| EP 1039307 | A1 | 27-09-2000 | CN | 1272920 A | 08-11-2000 |
| | | | EP | 1039307 A1 | 27-09-2000 |
| | | | JP | 3212984 B2 | 25-09-2001 |
| | | | TW | 434411 B | 16-05-2001 |
| | | | US | 6323634 B1 | 27-11-2001 |
| | | | WO | 0022447 A1 | 20-04-2000 |
| US 2011204889 | A1 | 25-08-2011 | CN | 102193021 A | 21-09-2011 |
| | | | JP | 2011174741 A | 08-09-2011 |
| | | | US | 2011204889 A1 | 25-08-2011 |

EPO FORM P0459

For more details about this annex : see Official Journal of the European Patent Office, No. 12/82